# EUROPEAN PATENT APPLICATION

(11) **EP 4 810 962 A1**
(43) Date of publication of application: **23.09.2026**
(21) Application number: 26161293.1
(22) Date of filing: 27.02.2026
(51) Int. Cl.: G01R 15/18, G01R 19/12, H02H 3/33

(54) **A METHOD FOR PROCESSING A CURRENT TRANSFORMER SIGNAL**

(30) Priority: 20.03.2025 CN 202510335955
(71) Applicant: SCHNEIDER ELECTRIC INDUSTRIES SAS, 92500 Rueil-Malmaison (FR)
(72) Inventor: LV, Dong, 201203 Shanghai (CN); SONG, Yangfeng, 201203 Shanghai (CN); TIAN, Simon, 201203 Shanghai (CN); LIU, Jiawei, 201203 Shanghai (CN); XU, Lingbo, 201203 Shanghai (CN); LI, Yongxin, 201203 Shanghai (CN); WEN, Jian, 201203 Shanghai (CN); FU, Xiaobo, 201203 Shanghai (CN)
(74) Representative: Lavoix

(57) **Abstract**

A method for processing a current transformer signal is provided, the method including: obtaining a current transformer signal with a cycle; in each cycle of the current transformer signal, for each time point, calculating a ratio between an amplitude of the current transformer signal at the time point and an amplitude of the current transformer signal at the previous time point; determining, in each cycle of the current transformer signal, that a tailing exists in the current transformer signal based on the ratio being equal to a tailing threshold and lasting for a threshold time; and in each cycle of the current transformer signal, removing the tailing.

## Description

### TECHNICAL FIELD

The present disclosure relates to a method for processing a current transformer signal, and in particular, relates to a method for identifying a tailing of a current transformer signal and reducing distortion of the current transformer signal.

### BACKGROUND

Current transformers are widely used components in electronic devices. For example, the residual current operation protection device may include a current transformer to collect a leakage current of a circuit, and when the leakage current is large, necessary measures can be taken in time. However, due to the characteristics of current transformer, the current transformer signal collected from the current transformer is often biased and retains only alternating current (AC) component of the signal sensed by the current transformer. Therefore, when the leakage current is a signal having a direct current (DC) pulse waveform (an AC sine wave missing half a cycle), the current transformer signal collected from the current transformer may be distorted, so that an error may occur in a subsequent operation based on the current transformer signal collected from the current transformer. For example, when the signal sensed by the current transformer is a leakage current having a DC pulse waveform, the current transformer signal (such as a current signal) collected from the current transformer is often biased and the current transformer signal gradually attenuates rather than immediately disappears after the AC component of the current transformer signal ends. The portion of the current transformer signal that exhibits attenuation characteristics may be referred to as a tailing of the current transformer signal.

Accordingly, the present disclosure proposes a method for processing a current transformer signal, the method may identify a tailing of the current transformer signal and restore the distortion of the current transformer signal, thereby eliminating negative effects of the distortion of the current transformer signal.

### SUMMARY

According to an aspect of an embodiment of the present invention, a method for processing a current transformer signal is provided, the method comprises: obtaining a current transformer signal with a cycle; in each cycle of the current transformer signal: for each time point, calculating a ratio between an amplitude of the current transformer signal at the time point and an amplitude at a previous time point; determining that a tailing exists in the current transformer signal based on the ratio being equal to a tailing threshold and lasting for a threshold time; and removing the tailing.

In some examples, the method further comprises: in each cycle of the current transformer signal, determining a time point at which the tailing of the current transformer signal is determined as a first time point.

In some examples, the method further comprises: based on the ratio no longer being equal to the tailing threshold, determining that the tailing of the current transformer signal ends and determining a current time point as a second time point.

In some examples, the tailing threshold is associated with a material of the current transformer.

In some examples, the threshold time is a preconfigured time.

In some examples, the method further comprises: before removing the tailing, applying a compensation value determined at a previous cycle of the current transformer signal to a present cycle of the current transformer signal.

In some examples, applying a compensation value determined at a previous cycle of the current transformer signal to a present cycle of the current transformer signal comprises: adding an amplitude at each time point of the present cycle of the current transformer signal to the compensation value determined at the previous cycle of the current transformer signal.

In some examples, the method further comprises: determining a compensation value for a next cycle of the current transformer signal based on a tailing of the present cycle of the current transformer signal to which the compensation value is applied.

In some examples, determining the compensation value for a next cycle of the current transformer signal comprises: determining an inverse of an amplitude at the first time point of the tailing of the present cycle of the current transformer signal as the compensation value for the next cycle of the current transformer signal.

In some examples, removing the tailing comprises: setting amplitudes between the first time point and the second time point of the tailing of the present cycle of the current transformer signal to zero.

According to another aspect of the embodiments of the present invention, a residual current operation protection device is provided, the device comprises: a current transformer; a trip unit; and a processing unit configured to process the current transformer signal according to the aforementioned method and to control the trip unit based on the processed current transformer signal.

According to another aspect of the embodiments of the present invention, a computer-readable storage medium is provided, having computer-executable instructions stored thereon, the instructions being used to implement the aforementioned method when executed by the processing unit.

Other aspects, advantages, and salient features of the present disclosure will become clear to those skilled in the art from the following detailed description in conjunction with the accompanying drawings which disclose various embodiments of the present disclosure.

### BRIEF DESCRIPTION OF DRAWINGS

The present invention will be more readily understood from the following detailed description with the aid of the accompanying drawings, in which like reference numerals designate elements of like structure, and in which:
FIG. 1A illustrates a flow chart of a method for processing a current transformer signal according to an embodiment of the present disclosure;
FIG. 1B illustrates a flow chart of another method for processing the current transformer signal according to an embodiment of the present disclosure;
FIG. 2 illustrates a simulation graph of an example current transformer signal according to an embodiment of the present disclosure;
FIG. 3 illustrates a schematic diagram of a residual current operation protection device according to an embodiment of the present disclosure; and
FIG. 4 illustrates a schematic diagram of a non-transitory computer-readable medium according to embodiments of the present disclosure.

Throughout the accompanying drawings, similar reference numerals will be understood to refer to similar parts, components, and structures.

### DETAILED DESCRIPTION

The technical solutions in the embodiments of the present invention will be described clearly and completely in the following in conjunction with the accompanying drawings in the embodiments of the present invention, and it is obvious that the described embodiments are a part of the embodiments of the present invention instead of all of the embodiments. Based on the embodiments in the present invention, all other embodiments obtained by a person of ordinary skill in the art without making creative labor fall within the scope of protection of the present invention.

In addition, one of ordinary skill in the art will understand that the elements in the accompanying drawings are illustrated for simplicity and may not necessarily be drawn to scale. For example, the dimensions of some elements in the accompanying drawings may be enlarged relative to other elements to help improve understanding of aspects of the embodiments. In addition, one or more elements may have been represented by various symbols in the accompanying drawings, and the accompanying drawings may show only those particular details that are relevant to an understanding of the embodiments of the present disclosure so that the accompanying drawings do not have to be obscured by details that would be obvious to a person of ordinary skill in the art who would benefit from the descriptions herein.

In addition, it should be noted that in this specification, A connected to B may mean "A is directly connected to B" or "A is connected to B via other intermediate". A connected between B and C may mean "A is directly connected to B and C" or "A is connected to B and C via other middleware". In addition, it should be noted that in this specification, "first" and "second" are used only to distinguish one element from another element, and are not used to rank or limit the importance or priority of different elements.

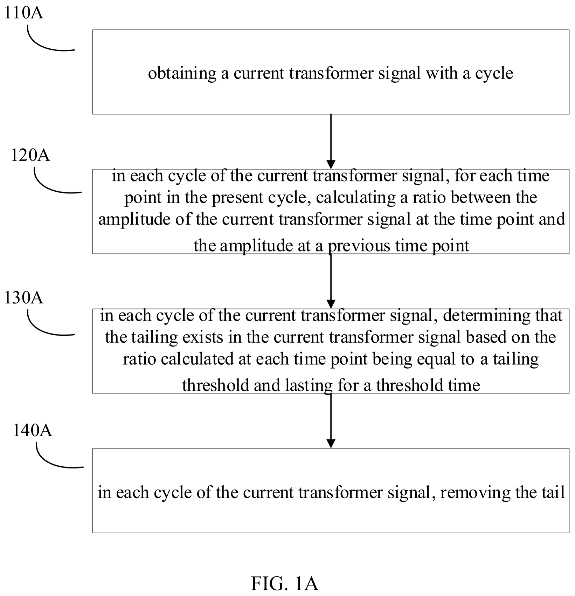

FIG. 1A illustrates a flow chart of a method for processing a current transformer signal according to an embodiment of the present disclosure.

At step S110A, a current transformer signal with a cycle may be obtained.

When a circuit produces a leakage current, it will produce a weak magnetic field. By placing a current transformer in the circuit, the magnetic field associated with the leakage current may be sensed and converted into a current signal, i.e. a current transformer signal with a cycle can be obtained. In some embodiments, the current transformer signal collected from the current transformer may also be amplified via a series of operational amplification circuits to reach a suitable amplitude. In some embodiments, the leakage current may be a signal with a DC pulse waveform, and accordingly, although the current transformer signal with a cycle collected by the current transformer is similar in waveform to a signal with a DC pulse waveform, due to the characteristics of the current transformer, there is usually signal distortion in the current transformer signal.

At step S120A, in each cycle of the current transformer signal, for each time point in the present cycle, a ratio is calculated between the amplitude of the current transformer signal at the time point and the amplitude at a previous time point.

As mentioned before, due to the characteristics of the current transformer, the current transformer signal with a cycle collected by the current transformer often suffers from signal distortion. For example, when the current transformer signal with a cycle is a signal having a DC pulse waveform, in each cycle of the current transformer signal, there is a bias in the current transformer signal, and when the AC component of the current transformer signal ends, its tail typically gradually attenuates (i.e., a tailing of the current transformer signal) rather than immediately disappears.

In each cycle of the current transformer signal, the tailing of the present cycle of the current transformer signal may be identified. Specifically, for each time point in the present cycle, a ratio between the amplitude of the current transformer signal at the current time point and the amplitude at the previous time point may be calculated, and the ratio may be compared to a tailing threshold.

At step S130A, in each cycle of the current transformer signal, it is determined that the tailing exists in the current transformer signal based on the ratio calculated at each time point being equal to the tailing threshold and lasting for a threshold time.

As described at step S120A, for each time point in the present cycle, a ratio between the amplitude of the current transformer signal at that time point and the amplitude at the previous time point is calculated and compared to the tailing threshold. If the ratio equals the tailing threshold and remains equal to the tailing threshold for the threshold time, it is determined that the tailing exists for the present cycle of the current transformer signal.

The tailing threshold may be associated with materials of the current transformer. In some embodiments, the tailing threshold and threshold time may be preconfigured. In some embodiments, the time when it is determined that there is a tailing n the present cycle of the current transformer signal may also be determined as a first time. Furthermore, if the ratio is no longer equal to the tailing threshold, it may be determined that the tailing of the current transformer signal ends and a time point at which the ratio is no longer equal to the tailing threshold may be determined as the second time point.

At step S140A, the tailing is removed in each cycle of the current transformer signal.

The tailing of the current transformer signal usually negatively affects the measurement of the current transformer signal, thereby affecting subsequent operations based on the current transformer signal. Therefore, it is necessary to remove at least part of the tailing portion of the current transformer signal to eliminate the negative effects caused by the tailing of the current transformer signal.

In each cycle of the current transformer signal, when a tailing of the present cycle of the current transformer signal is identified, the amplitude of a portion between the first time and the second time of the tailing may be set to zero, thereby removing at least part of the tailing of the current transformer signal.

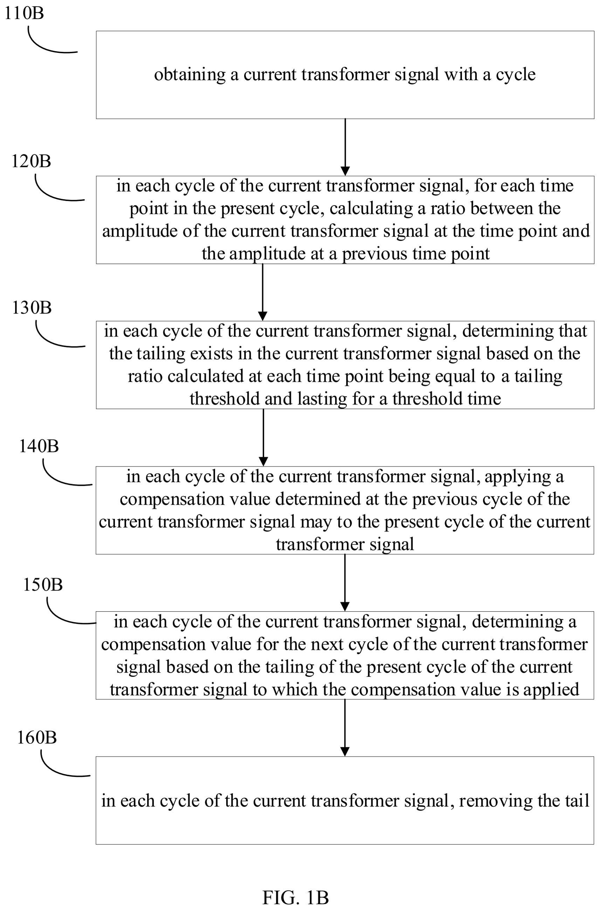

FIG. 1B illustrates a flow chart of another method for processing the current transformer signal according to an embodiment of the present disclosure.

The method illustrated in Figure 1B includes steps 110B, 120B, 130B, 140B, 150B and 160B, where 110B, 120B, 130B and 160B respectively correspond to steps 110A, 120A, 130A and 140A described in Figure 1A.

At step S 110B, a current transformer signal with a cycle may be obtained. At steps S120B and S130B, in each cycle of the current transformer signal, for each time point, a ratio between the amplitude of the current transformer signal at the time point and the amplitude at the previous time point may be calculated, and based on the ratio being equal to the tailing threshold and lasting for the threshold time, it is determined that the tailing exists in the current transformer signal. to the procedure for obtaining the current transformer signal with a cycle and identifying the tailing of the current transformer signal has been described in detail with reference to FIG. 1A, and will not be repeated here to avoid redundancy.

At step S 140B, in each cycle of the current transformer signal, a compensation value determined at the previous cycle of the current transformer signal may be applied to the present cycle of the current transformer signal.

In each cycle of the current transformer signal, the amplitude at each time point of the present cycle of the current transformer signal may be added to the compensation value determined at the previous cycle of the current transformer signal. By applying the compensation value in each cycle of the current transformer signal, the bias of the current transformer signal may be compensated. In some embodiments, the compensation value determined at the previous cycle of the current transformer signal may be obtained from a register. However, the present disclosure is not limited thereto, and the compensation value may be obtained from any component for storage. The method of determining the compensation value in each cycle of the current transformer signal for the next cycle of the current transformer signal is similar, and the determination of the compensation value will be described in step S150B.

At step S150B, in each cycle of the current transformer signal, a compensation value for the next cycle of the current transformer signal is determined based on the tailing of the present cycle of the current transformer signal to which the compensation value is applied.

In each cycle of the current transformer signal, the inverse of the amplitude at the first time point of the tailing of the present cycle of the current transformer signal may be determined as the compensation value for the next cycle of the current transformer signal. In some embodiments, the compensation value may be stored in a register, however, the present disclosure is not limited thereto and the compensation value determined at the present cycle for the next cycle may be stored in any suitable component.

At step S 160B, in each cycle of the current transformer signal, the tailing of the current transformer signal may be removed after determining the compensation value for the next cycle of the current transformer signal. The procedure for removing the tailing of the current transformer signal has been described in detail with reference to FIG. 1A, and will not be repeated here to avoid redundancy.

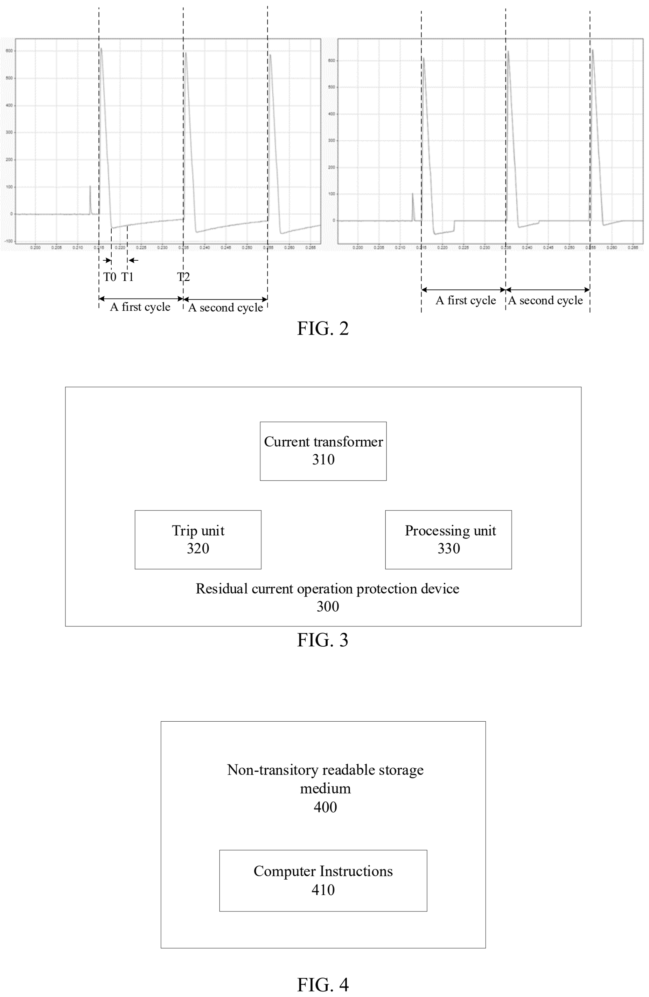

FIG. 2 illustrates a simulation graph of an example current transformer signal according to an embodiment of the present disclosure. The left portion of FIG. 2 shows a current transformer signal with a cycle obtained from a current transformer, and the right portion of FIG. 2 shows a processed current transformer signal with a cycle.

As shown in FIG. 2, in each cycle of the current transformer signal with a cycle collected from the current transformer, the current transformer signal may have a tailing. For example, for a first cycle of the current transformer signal shown in the left portion of FIG. 2, the amplitude of the current transformer signal is overall small due to the existence of the bias, so that there is a portion with amplitude smaller than zero. In addition, the gradual attenuation of the current transformer signal starting at time T0 results in the current transformer signal having a tailing starting at the time T0 and ending at time T2. Similarly, each of other cycles of the current transformer signal also have the bias and the tailing. Identification and removal of the tailing and compensation for the bias may be based on methods as described with reference to FIG. 1A and FIG. 1B. For example, in each cycle of the current transformer signal, at each time point, a ratio between the amplitude at the current time point and the amplitude at the previous time point of the current transformer signal may be calculated and whether the tailing exists is determined based on whether the ratio is equal to the tailing threshold. In some embodiments, the tailing threshold may be preconfigured. To avoid the impact of interference such as noise on the accuracy of identifying the tailing, it may be determined that the tailing exists in the present cycle of the current transformer signal based on the ratio being equal to the tailing threshold and remaining equal to the tailing threshold for the threshold time. In some embodiments, the threshold time may be preconfigured. For example, in the example current transformer signal shown in FIG. 2, the threshold time may be a time period from the time T0 to time T1.

When the ratio is no longer equal to the tailing threshold, as shown at time T2 in FIG. 2, it may be determined that the tailing of the present cycle of the current transformer signal ends.

In each cycle of the current transformer signal, the compensation value determined at the previous cycle of the current transformer signal may be applied to the present cycle of the current transformer signal to compensate the bias of the current transformer signal. For example, the compensation value determined at the first cycle of the current transformer signal may be applied to the second cycle of the current transformer signal by adding the compensation value determined at the first cycle of the current transformer signal to the amplitude at each time point of the second cycle of the current transformer signal. In some embodiments, if the present cycle is the first cycle and no compensation value determined for the present cycle, no compensation value may be applied to the present cycle.

In each cycle of the current transformer signal, the compensation value for the next cycle of the current transformer signal may also be determined. As shown in FIG. 2, the amplitude of the present cycle of the current transformer signal at the end of the threshold time, such as time T1, may be determined and the inverse of the amplitude may be determined as the compensation value for the next cycle of the current transformer signal. In some embodiments, if the present cycle is not the first cycle, the compensation value determined at the last cycle of the current transformer signal may first be applied to the present cycle of the current transformer signal before the compensation value for the next cycle of the current transformer signal is determined based on the aforementioned method.

The tailing of the current transformer signal may also be removed in each cycle of the current transformer signal. In particular, the amplitude of the tailing portion of the current transformer signal may be set to zero after the compensation value for the next cycle of the current transformer signal is determined. For example, in the example current transformer signal shown in FIG. 2, the amplitude between time T1 and time T2 in the tailing portion may be set to zero for the first cycle of the current transformer signal.

As shown in the right portion of FIG. 2, in each cycle of the processed current transformer signal with a cycle, the amplitude of a part of the tailing may be set to zero, and the bias of the current transformer signal may be compensated by applying the compensation value to remove negative effects of distortion of the current transformer signal.

FIG. 3 illustrates a schematic diagram of a residual current operation protection device according to an embodiment of the present disclosure.

As shown in FIG. 3, the residual current operation protection device 300 may include a current transformer 310, a trip unit 320 and a processing unit 330. However, the present disclosure is not limited thereto, and residual current operation protection device 300 may include more or fewer units than shown in FIG. 3.

The current transformer 310 may sense the magnetic field associated with the leakage current of the circuit in the residual current operation protection device and generate the current transformer signal with a cycle. The processing unit 330 may obtain the current transformer signal with a cycle from the current transformer 310. In some embodiments, the current transformer signal collected from the current transformer 310 may also be amplified via a series of operational amplification circuits to reach a suitable amplitude. The current transformer signal with a cycle obtained from the current transformer 310 may have signal distortion, e.g., in each cycle of the current transformer signal, the current transformer signal may have an bias and a tailing. The processing unit 330 may perform the methods described with reference to FIG. 1A and FIG. 1B to process current transformer signals with a cycle. The processing unit 330 may also calculate the valid value of the processed current transformer signal and control the trip unit 320 based on the calculated valid value. In some embodiments, the trip unit 320 may trip when the calculated valid value is greater than a predetermined threshold. Controlling the trip unit 320 based on the valid value calculated from the processed current transformer signal may provide for achieving a shorter actuation time, e.g., less than 40 milliseconds, compared to the controlling based on the valid value calculated from the unprocessed current transformer signal, resulting in a more accurate operation of the residual current operation protection device.

FIG. 4 illustrates a schematic diagram of a non-transitory computer-readable medium according to embodiments of the present disclosure.

As shown in FIG. 4, the non-transitory readable storage medium 400 has computer instructions 410 stored thereon, when executed by a processor, the processor may perform one or more of the steps in the method and additional aspects thereof as described above.

Exemplarily, the non-transitory readable storage medium 400 may be any combination of one or more computer-readable storage mediums, such as a computer-readable storage medium comprising program code for performing the various methods described above.

Exemplarily, when the program code is read by a computer, the computer may execute the program code stored in the computer storage medium, and perform one or more steps to implement, for example, the various methods described above and additional aspects thereof according to at least one embodiment of the present disclosure.

One of ordinary skill in the art may realize that the units and algorithmic steps of the embodiments described in connection with the embodiments disclosed in the present invention are capable of being realized in the electronic hardware, the computer software, or a combination of both, and that the composition and steps of the embodiments have been described in the foregoing description in general terms according to the functions, in order to clearly illustrate the interchangeability of hardware and software. Whether these functions are performed in hardware or software depends on the particular application and design constraints of the technical solution. The skilled person may use different methods for each particular application to implement the described functions, but such implementation should not be considered beyond the scope of the present invention.

It is clear to those skilled in the field to which it belongs that, for the convenience and brevity of the description, the specific working processes of the above-described systems, apparatuses and units may be referred to the corresponding processes in the foregoing embodiments of the methods, which will not be repeated herein.

In the several embodiments provided in the present invention, it should be understood that the disclosed systems, apparatuses and methods, may be realized in other ways. For example, the above-described embodiments of the device are merely example, e.g., the division of the units described, is merely a logical functional division, and the actual implementation may be divided in other ways, e.g., a plurality of units or components may be combined or may be integrated into another system, or some of the features may be ignored, or not implemented. Another point is that the mutual coupling or direct coupling or communication connection shown or discussed may be an indirect coupling or communication connection through some interface, device or unit, which may be electrical, mechanical or otherwise.

The units illustrated as separated components may or may not be physically separated, and components displayed as units may or may not be physical units, and may either be located in one place or may be distributed over a plurality of network units. Some or all of these units may be selected to fulfill the purpose of this embodiment scheme according to actual needs.

Furthermore, the functional units in the various embodiments of the present invention may be integrated in a single processing unit, or each unit may be physically present separately, or two or more units may be integrated in a single unit. The integrated unit may be realized either in the form of hardware or in the form of a software functional unit.

The integrated units may be stored in a computer-readable storage medium if realized in the form of a software functional unit and sold or used as a separate product. Based on this understanding, the technical solution of the present invention, in essence or as a contribution to the prior art, or all or part of the technical solution, may be embodied in the form of a software product, which is stored in a storage medium comprising a number of instructions to enable a computer device (which may be a personal computer, a server, or a network device, etc.) to carry out all or part of the steps of the method described in various embodiments of the invention, and the computer software product is stored in a storage medium comprising instructions to cause a computer device (which may be a personal computer, a server, a network device, etc.) to perform all or part of the steps of the method described in the various embodiments of the invention. The aforementioned storage medium includes a USB flash drive, a removable hard disk, a read-only memory (ROM, Read-Only Memory), a random access memory (RAM, Random Access Memory), a diskette or a CD-ROM, and other media that may store program code.

The foregoing are only specific embodiments of the present invention, but the scope of protection of the present invention is not limited thereto, and any person skilled in the art who is familiar with the technical field can easily think of changes or substitutions within the scope of the technology disclosed by the present invention, which should be covered by the scope of protection of the present invention. Therefore, the scope of protection of the present invention shall be stated to be subject to the scope of protection of the claims.

## Claims

1. A method for processing a current transformer signal, comprising:
obtaining a current transformer signal with a cycle;
in each cycle of the current transformer signal:
for each time point, calculating a ratio between an amplitude of the current transformer signal at the time point and an amplitude at a previous time point;
determining that a tailing exists in the current transformer signal based on the ratio being equal to a tailing threshold and lasting for a threshold time; and
removing the tailing.

2. The method of claim 1, further comprising:
in each cycle of the current transformer signal, determining a time point at which the tailing of the current transformer signal is determined as a first time point.

3. The method of claim 1 or 2, further comprising:
based on the ratio no longer being equal to the tailing threshold, determining that the tailing of the current transformer signal ends and determining a current time point as a second time point.

4. The method of any one of the preceding claims, wherein the tailing threshold is associated with a material of the current transformer.

5. The method of any one of the preceding claims, wherein the threshold time is a preconfigured time.

6. The method of any one of the preceding claims, further comprising:
before removing the tailing, applying a compensation value determined at a previous cycle of the current transformer signal to a present cycle of the current transformer signal.

7. The method of claim 6, wherein applying a compensation value determined at a previous cycle of the current transformer signal to a present cycle of the current transformer signal comprises:
adding an amplitude at each time point of the present cycle of the current transformer signal to the compensation value determined at the previous cycle of the current transformer signal.

8. The method of claim 6 or 7, further comprising:
determining a compensation value for a next cycle of the current transformer signal based on a tailing of the present cycle of the current transformer signal to which the compensation value is applied.

9. The method of claim 8, wherein determining the compensation value for a next cycle of the current transformer signal comprises:
determining an inverse of an amplitude at the first time point of the tailing of the present cycle of the current transformer signal as the compensation value for the next cycle of the current transformer signal.

10. The method of any one of the claims 3 to 9, wherein removing the tailing comprises:
setting amplitudes between the first time point and the second time point of the tailing of the present cycle of the current transformer signal to zero.

11. A residual current operation protection device, comprising:
a current transformer;
a trip unit; and
a processing unit configured to process a current transformer signal according to the method of any one of claims 1-10 and control the trip unit based on the processed current transformer signal.

12. A computer-readable storage medium having computer-executable instructions stored thereon, when executed by a processing unit, the instructions are used to implement the method of any one of claims 1-10.
